Europäisches Patentamt

European Patent Office

Office européen des brevets

(19)

(11) Publication number: **0 081 986**
**B1**

(12)                    EUROPEAN PATENT SPECIFICATION

(45) Date of publication of patent specification: **12.08.87**

(51) Int. Cl.⁴: **H 01 R 29/00, H 05 K 1/00**

(21) Application number: **82306593.3**

(22) Date of filing: **10.12.82**

(54) **Programmable header.**

(30) Priority: **11.12.81 US 329889**

(43) Date of publication of application:
**22.06.83 Bulletin 83/25**

(45) Publication of the grant of the patent:
**12.08.87 Bulletin 87/33**

(84) Designated Contracting States:
**AT BE CH DE FR GB IT LI LU NL SE**

(56) References cited:
**FR-A-2 320 681**
**US-A-3 747 209**
**US-A-3 891 898**
**US-A-4 090 667**

(73) Proprietor: **Miraco, Inc.**
**120 Northeastern Boulevard**
**Nashua New Hampshire 03062 (US)**

(72) Inventor: **Roberts, Joseph A.**
**19 Madison Drive**
**Hudson New Hampshire 03051 (US)**

(74) Representative: **Sommerville, John Henry et al**
**SOMMERVILLE & RUSHTON 11 Holywell Hill**
**St. Albans Hertfordshire, AL1 1EZ (GB)**

Courier Press, Leamington Spa, England.

## Description

This invention relates to programmable headers and, particularly, though not exclusively, to programmable headers of the dual incline package (DIP) type.

In the prior art there are a number of designs of programmable headers in which the interconnection between opposed pairs of pins of two lines of pins can be programmed as desired. In some of these designs the making and breaking of the interconnection is by means of a switch with each opposed pair of pins being connectable through a separate switch thereby permitting the programming of the interconnections to be adjusted at will. In other arrangements the interconnection between opposed pairs of pins is permanently broken during the programming operation to form a permanent program arrangement in the header. A further form of programmable header involves the use of a plurality of separate pins and terminals which are hard-wired together in a desired manner.

The programmable header using switches is expensive to produce, has a relatively complex mechanical structure which tends to reduce its reliability and is not susceptible to automatic insertion in circuit boards on an automatic component insertion line.

The second form of header referred to which is permanently programmed by severing interconnections between opposed or adjacent pairs of pins is also not susceptible to automatic insertion in printed circuit boards and, although connection between adjacent pins or opposite pairs of pins is provided, is very restricted as to the range of interconnections which can be programmed into the header.

Although the hard wired header can provide any desired complexity of pin interconnection, such a header is relatively expensive to manufacture and program and is prone to failure as a result of the breakdown of electrical connections therein. None of the previously proposed constructions of header facilitate the automatic insertion of the header into a circuit board, or the combination of low cost, coupled with great versatility of programming including the connection of any pin to any other pin without an undesired connection to one or more intermediate pins.

Examples of such prior art connectors are described in GB—A—1528277, US—A—3 747 209, US—A—4 090 667 and US—A—3 891 898.

It is an object of the present invention to provide an automatically insertable programmable header which is compact and economical to produce and which permits programming, during manufacture or by the user, of a wide range of interconnections between pins whether located adjacent one another or not.

It is a further object of the present invention to provide a method of constructing such a header.

According to the invention there is provided an integral lamina circuit arrangement comprising a plurality of electrically conductive pins in fixed spaced relationship, an electrically conductive highway, an electrically conductive lowway, a plurality of electrically conductive cross-links each connecting a separate one of said pins to said lowway and a plurality of electrically conductive side-links each connecting a separate one of said pins to said highway.

Also according to the invention there is provided a programmable header constructed from an integral lamina circuit arrangement comprising a plurality of electrically conductive pins in fixed spaced relationship, at least one electrically conductive highway, an electrically conductive lowway, a plurality of electrically conductive cross-links each connecting a separate one of said pins to said lowway and a plurality of electrically conductive side-links each connecting a separate one of said pins to a said highway, wherein said highway or highways lie in a plane or planes spaced from and parallel to a plane in which lies said lowway and are superimposed on but spaced from said cross-links, and wherein said pins project normal to said planes in spaced parallel relationship, said lowway and portions of said links being free from said superimposition thereby to facilitate selective removal of desired portions of said links and lowway to break electrical continuity thereof so as to program interconnection between said pins in a desired manner.

Also according to the invention there is provided a method of producing a programmable header comprising the steps of:

a) producing an integral lamina circuit arrangement comprising a plurality of electrically conductive pins in fixed spaced relationship, an electrically conductive highway, an electrically conductive lowway, a plurality of electrically conductive cross-links each connecting a separate one of said pins to said lowway and a plurality of electrically conductive side-links each connecting a separate one of said pins to said highway;

b) folding said links on fold lines placed so that said highway or highways lie in a plane or planes spaced from and parallel to a plane in which lies said lowway and are superimposed on but spaced from said cross-links, and said lowway and portions of said links are free from superimposition to facilitate selective removal of desired portions of said links and lowway to break electrical continuity thereof and

c) bending said pins to project (1) normal to said planes and (2) in spaced parallel relationship to one another.

The invention will now be described, by way of example, with reference to the accompanying drawings, in which:

Fig. 1 is an underview of a 16 pin programmable header according to the invention;

Fig. 2 is an end elevation of the programmable header shown in Fig. 1;

Fig. 3 illustrates the conductive circuit pattern used to form the programmable header shown in Figs. 1 and 2;

Fig. 4 is a sectional elevation on section line 4—4 shown in Fig. 1 with the outer housing of the header shown in ghost;

Fig. 5 is a fragmentary partially cut away plan view of an end portion of the conductor arrangement within the programmable header of Figs. 1, 2 and 4;

Fig. 6 is a fragmentary partially cut away perspective view of the conductor arrangement shown in Fig. 5;

Figs. 7 and 8 diagrammatically illustrate two examples of programmed interconnections possible in the programmable header of Figs. 1 and 2;

Figs. 9—15 diagrammatically illustrate the method of forming the programmable header illustrated in Figs. 1 and 2;

Fig. 16 is a plan view of a programmable header similar to that shown in Fig. 1 with an alternative arrangement for programming the pin interconnection of the header; and

Fig. 17 illustrates diagrammatically an alternative conductive circuit arrangement for a programmable header according to the present invention.

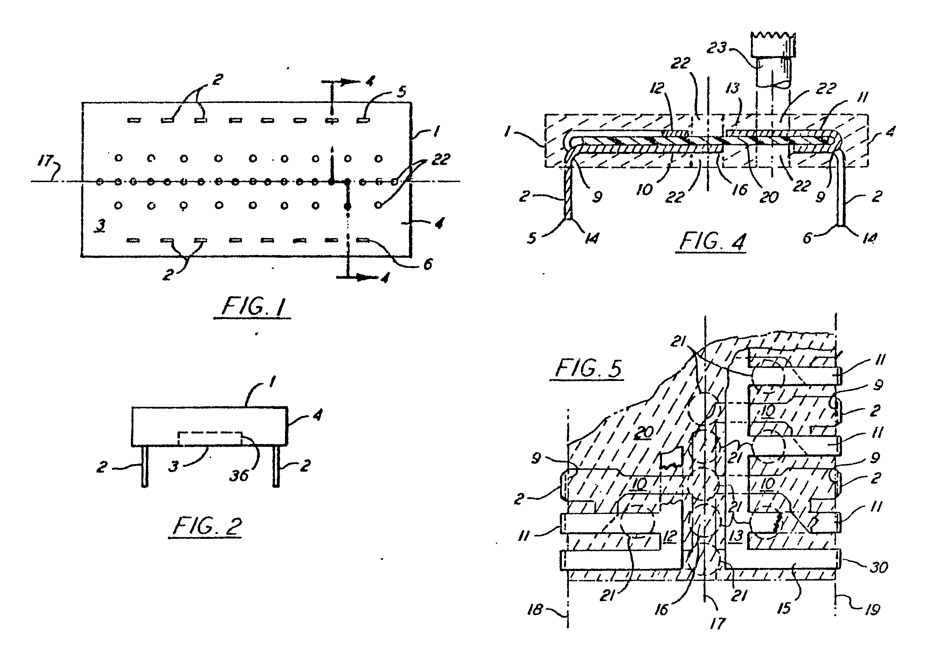

With reference to Figs. 1 and 2, there is illustrated a DIP (Dual Incline Programmable) header 1 having sixteen electrically conductive pins 2 projecting from the undersurface 3 of electrically non-conductive housing 4 in two side-by-side parallel lines 5, 6 of eight parallel pins each. The non-conductive housing 4 is of substantially rect- · angular construction suitable for automatic handling and insertion at a desired location on a printed circuit board on an automated circuit board component assembly line.

The conductive circuit arrangement interconnecting the pins within the programmable header shown in Figs 1 and 2 is illustrated in Fig. 3 and this figure shows the circuit in laminar form as it appears at an early stage during the production of the programmable header. The metallic (e.g. copper, phosphor bronze) conductor arrangement includes the sixteen pins 2 disposed in a mirror image pair of rows 7 and 8 forming eight mirror image pairs of pins with the adjacent ends 9 of each pair of pins being electrically interconnected by a conductive cross-link 10. The adjacent end 9 of each pin of row 7 and the associated cross-link 10 is electrically connected by a conductive side-link 11 to a first electrically conductive highway 12. Similarly, the adjacent ends 9 and associated cross-links 10 of row 8 are individually electrically connected by conductive side-links 11 to a second electrically conductive highway 13. The highways 12 and 13 each extend the length of the rows of pins 7 and 8 adjacent remote ends 14 of the pins 2 and are electrically connected to each other by end-links 15. The centers of the cross-links 10 and end-links 15 are interconnected by an electrically conductive lowway 16 extending parallel to the highways 12 and 13 to form, with the pins 2, cross-links 10, side-links 11, highways 12 and 13 and end-links 15, a mirror image conductive circuit arrangement symmetrically disposed about longitudinal axis 17 which extends centrally along the conductive lowway 16.

For clarity and the convenience of the above description of the circuit arrangement and as illustrated in Fig. 3 the remote ends of the pins 2 are shown spaced from the highways 12 and 13. However, it will be appreciated that during the early stages of manufacture of the circuit arrangement the remote ends 14 and conductive highways 12, 13 may or may not be integral and that during the production of a programmable header these remote ends 14 and highways 12, 13, when integral, are severed from one another as will be described in greater detail hereinafter.

The side-links 11 and end-links 15 are adapted to be folded about fold lines 18 and 19 respectively, the fold lines being parallel to and equally spaced on opposite sides of the axis 17. In addition, the pins 2 of each row are adapted to be bent at adjacent ends 9 to form the parallel lines of pins 5 and 6.

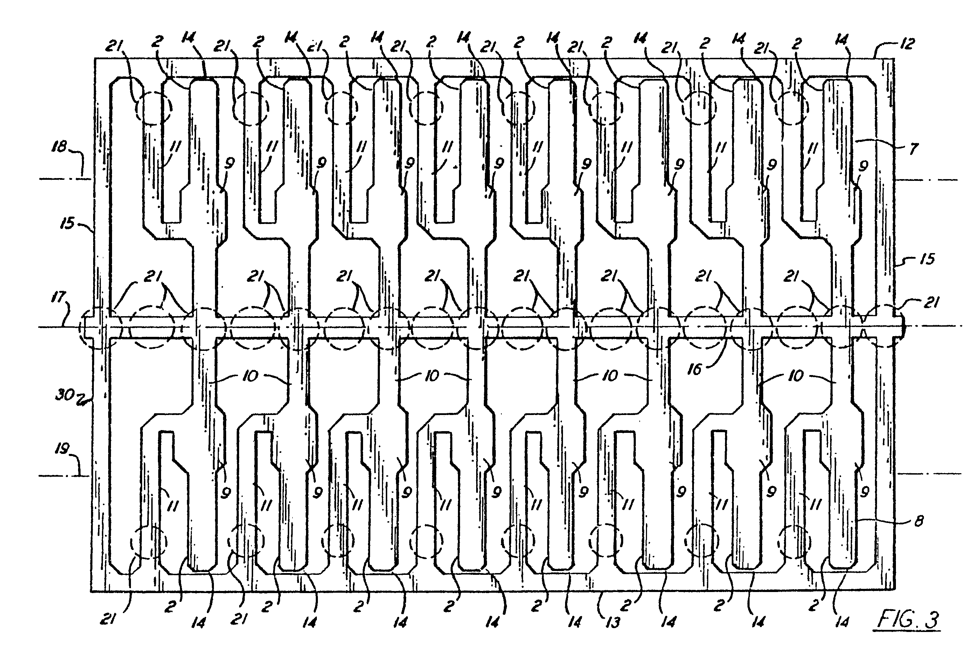

Figs. 4, 5 and 6 illustrate the conductor arrangement within the housing 4, in which the circuit arrangement of Fig. 3 is disposed in a folded symmetrical layout with the pins 2 projecting from the underside of the housing 4 and with the highways 12 and 13 disposed in spaced apart parallel relationship overlying the cross-links 10 on either side of the lowway 16, with the portions of the circuit arrangement on a level with the highways 12 and 13 being spaced from the portions of the circuit arrangement on the level of the lowway 16 by a layer of Mylar 20 (Trademark of E. I. DuPont de Nemour for polyester film) (Fig. 4 and 5).

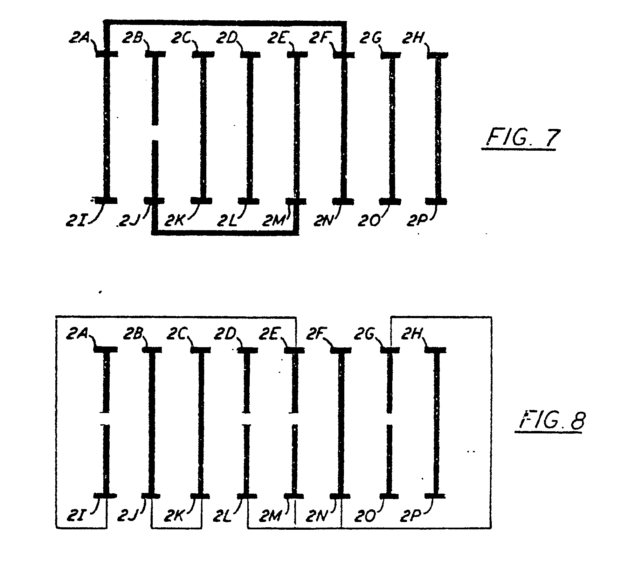

A desired arrangement of interconnections between the pins 2 is achieved by removing one or more portions of the circuit arrangement at the locations 21 shown in ghost Figs. 3, 4 and 5. Although the removal of this material may take place during the production of the programmable headers by punching, drilling, laser cutting, etc., the programmable header herein described with reference to the drawings is constructed to permit the programming of the interconnections between the pins within the header subsequent to final assembly by the end user. This is achieved by the provision of a plurality of passages 22 extending through the housing 4 at each of the locations 21 thereby to permit removal of the conductive material, as desired at any one or more of the locations 21, by means of a punch 23 (Fig. 4) sized to be guided by the passages 22 and to remove the amount of material at a location 21 required to break electrical continuity thereat. Typically the cross-, side- and end-link and lowway and highway widths may be 0.002 inches wide and the punch 0.025 inches diameter. By selectively removing portions of the circuit arrangement at locations 21, a desired program of interconnections between pins 2 may be achieved with a very wide range of interconnection arrangements being possible in which any pin may be electrically isolated from or left connected to any other pin or pins of the header. Two of the many possible arrangements are illustrated in Figs. 7 and 8 which show examples of circuit programming of connections between sixteen pins 2A to 2P which may be achieved with the circuit arrangement shown in Fig. 3. Greater versatility of interconnection is possible where additional portions 21 are arranged for removal in each cross-link 10 between the adjacent ends 9 of the pins 2 and the lowway 16.

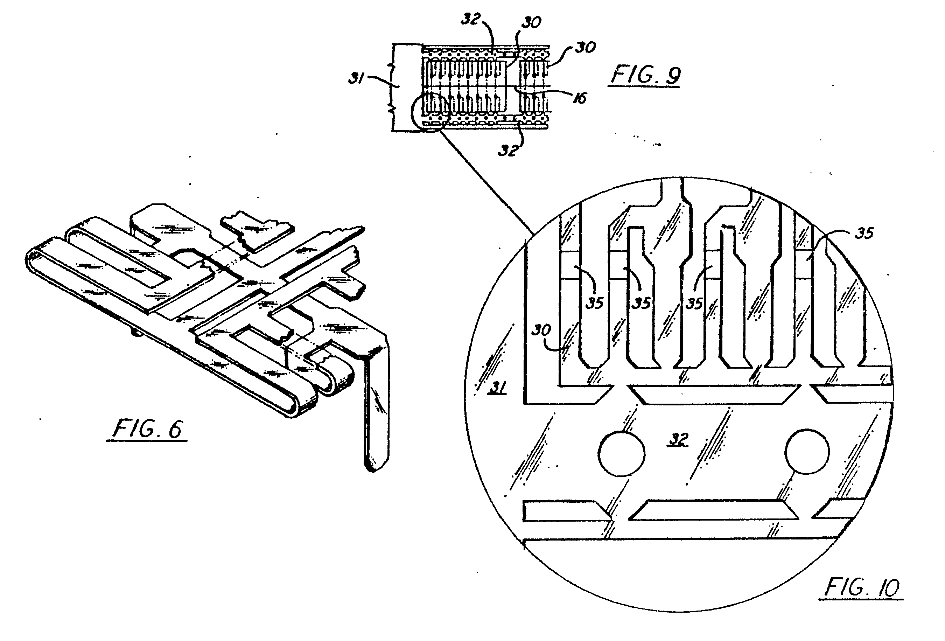

Figs. 9 through 15 illustrate a manner of manufacturing a programmable header of the present invention. As shown in Fig. 9 and Fig. 10 (which shows enlarged the portion circled in Fig. 9) a plurality of circuit arrangements 30, each like the circuit arrangement shown in Fig. 3, are sequentially produced from an electrically conductive strip 31 by photoimaging and etching, the arrangements 30 being interconnected by their conductive lowways 16 and being supported by support and transport strips 32 disposed one on either side of the interconnected circuit arrangements 30. Although the method of production of the circuit arrangements is specified here as involving etching, and the associated photoimaging techniques, it will be understood that the circuit arrangements may be formed employing additive techniques, for example, plating up, mechanical stamping techniques, screening on of conductive inks such as metal filled epoxy, etc. Further, it will be understood that similar techniques, including chemical milling (etching) may be used to provide a circuit arrangement in which the thickness of copper layer is as desired, for example to produce pins of greater thickness and rigidity than the other portions of the circuit arrangement. In addition, it will be understood that desired parts of the circuit arrangement may be tinned and/or plated, for example, the portions of the pins 2 which will be exposed may be gold plated.

More specifically, the circuit arrangements 30 are sequentially produced by an etching process as follows. A 0.254 mm (0.010 inch) thick copper strip is cleaned employing conventional cleaning techniques, and the cleansed surface is then coated at a coating station with a conventional resist layer. A positive resist is preferred so that multiple imaging and developing stages may be employed, if desired (for example, to plate pins with gold). Various positive resists are known in the art and are available commercially. For the purposes of this example AZ type positive resist available from the Shipley Co., Newton, Mass., is used. The resist layer is then exposed to light, at an imaging station, to form a positive art work image of the circuit pathways and pins. Those areas of the resist exposed to light are altered and removed from the sheet in the developing operation in which the strip is immersed in a preferential solvent for the resist (for example, sodium hydroxide solution), and developed at a treating station, with the result that the exposed portions of resist layer are dissolved leaving a resist layer in a positive image of the circuit pathways and pins.

The next step in the process involves contacting the exposed metallic areas of metal foil with an acid etching solution at an etching station. Etching removes the metal from all the uncovered areas of the metal film, leaving the areas of metal film covered by the resist intact.

Following removal of the uncovered areas of the metal film the resist layer is dissolved and the formed circuit arrangement now remaining is tinned, if desired, at a tinning station.

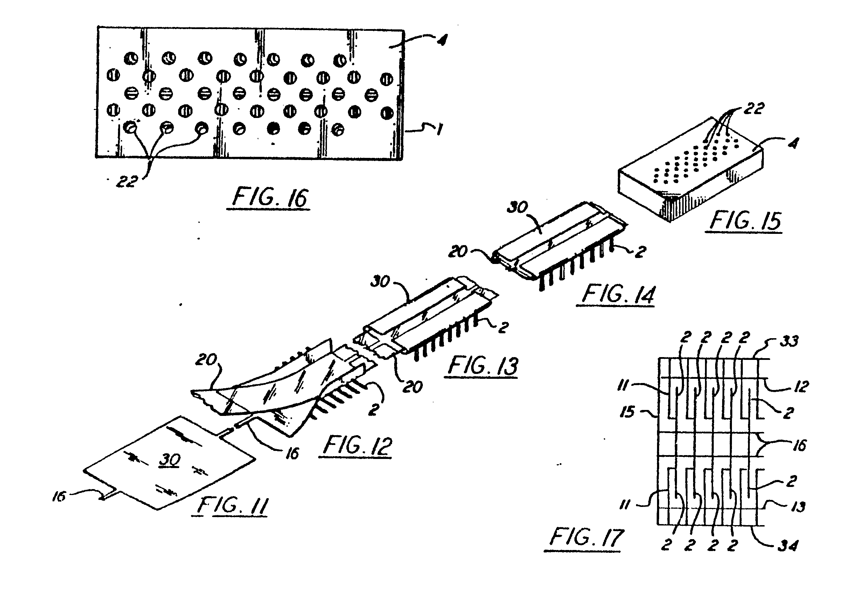

Following formation of the circuit arrangements, in a stamping and folding station (Fig. 12), the remote ends 14 of the pins 2 are severed from highways 12 and 13 and the side-links 11 and end-links 15 are bent, on fold lines 18 and 19, upwardly until their outer portions and highway 12 and 13 lie substantially normal to the pins and portions of the circuit arrangement lying between the fold lines. At the same time the support and transport strips 32 (not shown in Figs. 11 to 15), which serve to support and convey the serially connected circuit arrangements during production, are severed from the circuit arrangements.

A strip of Mylar is now superimposed over the circuit arrangements (Fig. 12) between the fold lines 18 and 19 and the side-links 11 and end-links 15 are folded on fold lines 18 and 19 over the Mylar strip (Fig. 13), with the Mylar layer preventing electrical communication between the highways 12, 13 and the pins 2 and lowway 16 except by the electrical connection provided by the folded side-links 11 and end-links 15 (Figs. 12 and 13). Subsequently the pins 2 are bent in the opposite direction to the folding of the side-links and end-links to form the arrangement described with reference to Figs. 4, 5 and 6. The serial strip of circuit arrangements 30 is then severed into separate discreet programmable header circuit arrangements and male and female moldings are assembled to the circuit arrangement and heat sealed to form the insulative housing 4, with the two rows of pins 5 and 6 projecting therefrom and with the passages 22 formed to permit access, by the punch 23, to each of the locations 21. Alternatively the male and female moldings may be ultrasonically welded to form the housing or the housing may be a single piece injection molded in place on the circuit arrangement with passages 22 formed at the same time.

Areas 35 (Figure 10) of the circuit arrangements 30 which are to be bent or folded about fold lines 18, 19 may be etched down or notched to facilitate folding.

An integrated circuit insertion tool engaging slot, groove or recess 36 (shown in phantom in Figure 2) may be provided in housing 4 to facilitate automated insertion.

Figure 16 illustrates an alternative layout of portions 21 which are removable to program the header as indicated by the locations of passages 22. This arrangement, in which portions 21 are located (1) in the lowway 16 between each cross-link 10, (2) in each cross-link 10 between lowway 10 and associated adjacent end 9, (3) in each end-link 15 on either side of lowway 10 and (4) in each side-link 11 close to its connection to the associated pin 2, permits adequate material to be provided in between passages 22 for housing strength to be maximized.

In an alternative arrangement portions 21 are removed by the application of electrical current, therethrough, of a magnitude to fuse the portion. To facilitate this the portions 21 may be of a smaller cross-sectional area than other parts of the circuit arrangement. Of course, when the circuit arrangement is to be programmed during manufacture, the passages 22 may be omitted, if desired.

It will be appreciated that a number of other arrangements utilizing the concept of the present invention are possible. For example, the side-links 11, end-links 15 and pins 2 could all be bent in the same direction so that the highways 12 and 13 underlie rather than overlie the cross-links 10 or the portions folded could be folded in opposite directions so that one highway overlies and the other highway underlies the cross-links.

In a further embodiment of the invention, illustrating but one way in which the inventive concept can be expanded to provide greater range of programmable connections between pins 2, a circuit arrangement as illustrated diagrammatically in Fig. 17 may be used. In this arrangement the side-links 11 and end-links 15 are extended beyond the highways 12 and 13 to a second pair of highways 33 and 34 which extend in spaced relationship parallel to highways 12 and 13. In this arrangement the length of the cross-links 10 is extended in order that an additional lowway 16 may be accommodated and so that, when the side-links and end-links are folded, the highways 12, 13, 33 and 34 all overlie portions of the cross-links between adjacent ends 9 of the pins 2 and the central lowways 16. Many other variations will be apparent to a man skilled in the art including the use of multiple lowways extending in spaced parallel arrangements.

Although the exemplary description of the invention has been with reference to a 16 pin DIP, it will be appreciated that the inventive concept is applicable to other pin arrangements including both DIP and single inline package (SIP) pin configurations and header pin arrangements not falling within these categories, for example, a circular pin arrangement.

In addition the inventive concept extends to constructions of programmable headers in which one or more circuit arrangements as herein described and claimed are superimposed on one or more similar or different circuit arrangements and electrically connected thereto to provide greater programming flexibility. In such an arrangement, with superimposed circuit arrangements both having highways, the side and end-links may be folded in opposite directions.

As used herein "superimposed" includes to "overlie" and to "underlie".

## Claims

1. An integral lamina circuit arrangement characterized by comprising a plurality of electrically conductive pins (2) in fixed spaced relationship, an electrically conductive highway (12, 13), an electrically conductive lowway (16), a plurality of electrically conductive cross-links (10) each connecting a separate one of said pins to said lowway and a plurality of electrically conductive side-links (11) each connecting a separate one of said pins to said highway.

2. A circuit arrangement according to Claim 1, and characterized by the following features;

(a) a plurality of pairs of said pins disposed in two rows (7, 8) with said lowway disposed therebetween, one said row (7) lying between said lowway (16) and a first said highway (12) and the other said row (8) lying between said lowway and a second said highway (13), the pins of said one row being connected by individual said side-links (11) to said first highway, the pins of said other row being connected by individual said side-links to said second highway and all said pins being connected by individual said cross-links to said lowway;

(b) said pins project normal to the lamina in spaced parallel relationship; and

(c) portions of said lowways and links (10, 11, 15) have broken electrical continuity to provide a desired programming of interconnection.

3. A circuit arrangement according to Claim 2 and characterized by the following features:

(a) electrically conductive end links (15) interconnect said first highway (12), said second highway (13) and said lowway (16);

(b) said highways and said lowway are parallel to one another and the circuit is symmetrically arranged about said lowway with said links (10, 11, 15) and pins disposed normal to said highways and said lowway;

(c) comprising sixteen pins disposed in two mirror image rows (7, 8) of eight; and

(d) at least one additional highway (33, 34) is disposed parallel to said first and second highways and is electrically connected conductively to said first or second highway by extensions of the side-links (11) associated with that highway, if desired including at least one additional lowway (16) is disposed between said rows of pins parallel to the first said lowway and is electrically connected conductively thereto by extensions of said cross-links (10).

4. A programmable header constructed from a circuit arrangement according to Claim 1, 2, or 3, characterized in that said highway or highways (12, 13) lie in a plane or planes spaced from and parallel to a plane in which lies said lowway (16) and are superimposed on but spaced from said cross-links (10), and wherein said pins project normal to said planes in spaced parallel relationship, said lowway and portions of said links (10, 11, 15) being free from said superimposition thereby to facilitate selective removal of desired portions (21) of said links and lowway to break electrical continuity thereof so as to program interconnection between said pins in a desired manner.

5. A programmable header according to Claim 4, characterized by the following features:

(a) the superimposed portions are spaced by a layer (20) of electrically insulating material;

(b) an insulative housing (4) encompassing the circuit arrangement except for said pins (2) which project in spaced parallel arrangement from said housing, said housing having passages (22) extending therethrough normal to said planes to provide access to said desired portions (21) of said links (10, 11, 15) and lowways (16) to facilitate said selective removal; and wherein

(i) said passages preferably are located at each interconnection of said lowway and a link, between each such interconnection on said·lowway and on each side-link;

(ii) each said passage preferably is adapted to guide a portion removing punch (23); and

(c) portions of said lowways and links have broken electrical continuity to provide a desired programming of interconnection between said pins;

(d) wherein desired portions of said arrangement are of a smaller cross-sectional area, relative to other portions of said arrangement, thereby to facilitate removal of said desired portions; and

(e) said selective removal is achieved by applying an electrical current to said desired portions, said current being of a magnitude to fuse said desired portions.

6. A programmable header according to Claim 5, characterized by the following features:

(a) said housing (4) is adapted for use in a circuit board auto-component insertion arrangement;

(b) said header is in the form of a dual incline package; and

(c) portions of said lowways (16) and links (10, 11, 15) have broken electrical continuity to provide a desired programming of interconnection between said pins.

7. A method of producing a programmable header, characterized by the steps of:

(a) producing an integral lamina circuit arrangement comprising a plurality of electrically conductive pins (2) in fixed spaced relationship, an electrically conductive highway (12, 13), and an electrically conductive lowway (16), a plurality of electrically conductive cross-links (10) each connecting a separate one of said pins to said lowway and a plurality of electrically conductive side-links (11) each connecting a separate one of said pins to said highway;

(b) folding said links on fold lines (18, 19) placed so that said highway or highways lie in a plane or planes spaced from and parallel to a plane in which lies said lowway and are superimposed on but spaced from said cross-links, and said lowway (16) and portions (21) of said links (10, 11, 15) are free from superimposition to facilitate selective removal of desired portions of said links and lowway to break electrical continuity thereof; and

(c) bending said pins to project (1) normal to said planes and (2) in spaced parallel relationship to one another.

8. A method according to Claim 7, and characterized by further steps of:

(d) removing said portions (21) selectively to provide a desired programming of the interconnection between said pins (2);

(e) encapsulating said circuit arrangement in a housing (4) with said pins projecting therefrom, said housing having passages (22) to provide access to said circuit arrangement to facilitate removal of said desired portions (21).

9. A method according to Claim 7 characterized by the following features:

(i) portions (21) of said lowways (16) and links (10, 11, 15) are removed prior to step (b);

(ii) said selective removal is achieved by applying an electrical current to said desired portions, said current being of a magnitude to fuse said desired portions;

(iii) portions of said circuit arrangement have a reduced cross-section to facilitate said folding on said fold lines (18, 19); and

(iv) forming said portions with a smaller cross-sectional area than other parts of said arrangement.

10. A method according to Claim 7, 8 or 9 characterized by applying an electrical current to said selected portions (21) of said arrangement, said current being of a magnitude to fuse said portions.

11. A method according to Claim 10, characterized by forming said portions (21) with a smaller cross-sectional area than other parts of said arrangement.

**Patentansprüche**

1. Einstückig und schichtförmig ausgebildete Schaltungsanordnung, gekennzeichnet durch eine Anzahl von elektrisch leitenden stiftförmigen Kontaktelementen (2), die bestimmte Abstände voneinander aufweisen, durch eine elektrisch leitende obere Bahn (12, 13), durch eine elektrisch leitende untere Bahn (16), durch eine Anzahl von elektrisch leitenden Querverbindungen (10), von denen jede ein besonderes der Kontaktelemente mit der unteren Bahn verbindet, und durch eine Anzahl von elektrisch leitenden seitlichen Verbindungen (11), von denen jede ein besonderes der Kontaktelemente mit der oberen Bahn verbindet.

2. Schaltungsanordnung nach Anspruch 1, gekennzeichnet durch die Merkmale:

(a) eine Anzahl von Paaren der Kontaktelemente, die in zwei Reihen (7, 8) angeordnet sind, zwischen denen die untere Bahn angeordnet ist, wobei eine Reihe (7) zwischen der unteren Bahn (16) und einer ersten oberen Bahn (12) und die andere Reihe (8) zwischen der unteren Bahn und einer zweiten oberen Bahn (13) angeordnet ist, wobei die Kontaktelemente der einen Reihe durch individuelle seitliche Verbindungen (11) mit der ersten oberen Bahn verbunden sind, wobei die Kontaktelemente der anderen Reihe durch individuelle seitliche Verbindungen mit der zweiten oberen Bahn verbunden sind und wobei alle Kontaktelemente durch individuelle seitliche Verbindungen mit der unteren Bahn verbunden sind,

(b) wobei die Kontaktelemente senkrecht von der Schicht vorragen und in Abständen und parallel zueinander angeordnet sind und

(c) wobei Teile der unteren Bahnen und der Verbindungen (10, 11, 15) eine unterbrochene elektrische Kontinuität aufweisen, um eine gewünschte Verbindungs-Programmierung zu erzielen.

3. Schaltungsanordnung nach Anspruch 2, gekennzeichnet durch die Merkmale:

(a) elektrisch leitende Endverbindungen (15), welche mit der ersten oberen Bahn (12), der zweiten oberen Bahn (13) und der unteren Bahn (16) in Verbindung stehen,

(b) wobei die oberen Bahnen und die untere Bahn parallel zueinander verlaufen und die Schaltung symmetrisch über der unteren Bahn angeordnet ist, wenn die Verbindungen (10, 11, 15) und die Kontaktelemente senkrecht zu den oberen Bahnen und der unteren Bahn angeordnet sind,

(c) wobei sechzehn Kontaktelemente in zwei spiegelbildlichen Reihen (7, 8) mit acht Kontaktelementen angeordnet sind und

(d) wobei mindestens eine zusätzliche obere Bahn (33, 34) parallel zu den ersten und zweiten oberen Bahnen angeordnet ist und elektrisch leitend mit der ersten oder der zweiten oberen Bahn durch Ansätze der seitlichen Verbindungen (11) verbunden ist, die diesser oberen Bahn zugeordnet sind, und wobei gewünschtenfalls mindestens eine zusätzliche untere Bahn (16) zwischen den Reihen von Kontaktelementen parallel zu der ersten unteren Bahn angeordnet ist und elektrisch leitend durch Ansätze der Querverbindungen (10) damit verbunden ist.

4. Programmierbarer Halter, der eine Schaltungsanordnung nach Anspruch 1, 2 oder 3 aufweist, dadurch gekennzeichnet, daß der oder die oberen Bahnen (12, 13) in einer Ebene oder in Ebenen liegen, die getrennt von und parallel zu einer Ebene verlaufen, in der die untere Bahn (16) liegt und übereinanderliegend, aber in einem Abstand von den Querverbindungen (10) angeordnet sind, daß die Kontaktelemente senkrecht von den Ebenen vorragen und in Abständen voneinander und parallel zueinander angeordnet sind, und daß die untere Bahn und Teile der Verbindungen (10, 11, 15) sich nicht überlagern, um eine einfache selektive Entfernung gewünschter Teile (21) der Verbindungen und der unteren Bahn zur Unterbrechung der elektrischen Kontinuität davon zu ermöglichen, so daß eine gewünschte Verbindungs-Programmierung zwischen den Kontaktelementen herstellbar ist.

5. Programmierbarer Halter nach Anspruch 4, gekennzeichnet durch die folgenden Merkmale:

(a) die sich überlagernden Teile sind durch eine Schicht (20) aus elektrisch isolierendem Material getrennt,

(b) ein isolierendes Gehäuse (4) umgibt die Schaltungsanordnung mit der Ausnahme der Kontaktelemente (2), die getrennt voneinander und parallel zueinander von dem Gehäuse vorragen, welches Gehäuse Durchgänge (22) aufweist, die sich durch das Gehäuse senkrecht zu den Ebenen erstrecken, um einen Zugang zu den gewünschten Teilen (21) der Verbindungen (10, 11, 15) und den unteren Bahnen (16) zu ermöglichen und dadurch die selektive Entfernung zu vereinfachen, und wobei

(I) die Durchgänge vorzugsweise an jeder Verbindungsstelle der unteren Bahn und einer Verbindung vorgesehen sind, zwischen jeder derartigen Verbindungsstelle auf der unteren Bahn und auf jeder seitlichen Verbindung,

(II) jeder Durchgang vorzugsweise derart ausgebildet ist, daß dadurch ein Teil eines zur Entfernung dienenden Stempels (23) geführt wird,

(c) Teile der unteren Bahnen und Verbindungen eine unterbrochene elektrische Kontinuität aufweisen, um eine gewünschte Programmierung der Verbindung zwischen den Kontaktelementen zu ermöglichen,

(d) gewünschte Teile der Anordnung eine kleinere Querschnittsfläche relativ zu anderen Teilen der Anordnung aufweisen, um eine vereinfachte Entfernung der gewünschten Teile su ermöglichen, und wobei

(e) die selektive Entfernung durch Zufuhr eines elektrischen Stroms zu den gewünschten Teilen bewirkt wird, dessen Stromstärke zum Schmelzen der gewünschten Teile ausreicht.

6. Programmierbarer Halter nach Anspruch 5, gekennzeichnet durch die folgenden Merkmale:

(a) das Gehäuse (4) ist derart ausgebildet, daß es mit einer automatischen Einsetzeinrichtung an einer Schaltungsplatte eingesetzt werden kann,

(b) der Halter hat die Form eines Doppelreihen-Gehäuses und

(c) Teile der unteren Bahn (16) und der Verbindungen (10, 11, 15) haben eine unterbrochene elektrische Kontinuität, um eine gewünschte Verbindungs-Programmierung zwischen den Kontaktelementen zu ermöglichen.

7. Verfahren zur Herstellung eines Programmierbaren Halters, gekennzeichnet durch die Schritte:

(a) eine integrale und schichtförmige Schaltungsanordnung wird ausgebildet, die eine Anzahl von elektrisch leitenden Kontaktelementen (2) in bestimmten Abständen voneinander aufweist, eine elektrisch leitende obere Bahn (12, 13) und eine elektrisch leitende untere Bahn (16), sowie eine Anzahl von elektrisch leitenden Querverbindungen (10) aufweist, von denen jede ein besonderes Kontaktelement mit der unteren Bahn verbindet, sowie ferner eine Anzahl von elektrisch leitenden seitlichen Verbindungen (11) aufweist, von denen jede ein besonderes Kontaktelement mit der oberen Bahn verbindet,

(b) Umfalten der Verbindungen um derart angeordnete Faltlinien (18, 19), daß die obere Bahn oder die oberen Bahnen in einer Ebene oder in Ebenen liegen, die in einem Abstand von und parallel zu einer Ebene angeordnet sind, in der die untere Bahn liegt, und die übereinanderliegend, aber getrennt von den Querverbindungen angeordnet werden, wobei die untere Bahn (16) und Teile (21) der Verbindungen (10, 11, 15) keine Überlagerung aufweisen, um eine selektive Entfernung von gewünschten Teilen der Verbindungen und der unteren Bahn zur Trennung der elektrischen Kontinuität zu ermöglichen, und

(c) die Kontaktelemente derart umgebogen werden, daß sie erstens senkrecht zu den Ebenen vorragen und zweitens getrennt voneinander und parallel zueinander verlaufen.

8. Verfahren nach Anspruch 7, gekennzeichnet durch die Schritte:

(d) die Teile (21) werden selektiv entfernt, um eine gewünschte Programmierung der Verbindung zwischen den Kontaktelementen (2) zu erzielen,

(e) die Schaltungsanordnung wird durch ein Gehäuse (4) eingekapselt, durch das die Kontaktelemente vorragen, welches Gehäuse Durchgänge (22) aufweist, um einen Zugang zu der Schaltungsanordnung zur Vereinfachung der Entfernung der gewünschten Teile (21) zu ermöglichen.

9. Verfahren nach Anspruch 7, gekennzeichnet durch die folgenden Merkmale:

(I) Teile (21) der unteren Bahnen (16) und Verbindungen (10, 11, 15) werden vor den Schritt (b) entfernt,

(II) die selektiv Entfernung erfolgt durch Zufuhr eines elektrischen Stroms zu den gewünschten Teilen, dessen Stromstärke zum Schmelzen der gewünschten Teile ausreicht,

(III) Teile der Schaltungsanordnung haben einen verringerten Querschnitt, um das Umfalten um die Faltlinien (18, 19) zu vereinfachen, und

(IV) Ausbildung der Teile mit kleinerem Querschnitt als andere Teile der Anordnung.

10. Verfahren nach Anspruch 7, 8 oder 9, gekennzeichnet durch Zufuhr eines elektrischen Stroms zu den ausgewählten Teilen (21) der Anordnung, welcher eine Stromstärke hat, die zum Schmelzen der Teile ausreicht.

11. Verfahren nach Anspruch 10, gekennzeichnet durch Ausbildung der Teile (21) mit einer Querschnittsfläche, die kleiner als diejenige anderer Teile der Anordnung ist.

**Revendications**

1. Un circuit composé d'une lamelle, caractérisé par le fait qu'il comprend une pluralité de broches (2) électriquement conductrices, ayant un espacement constant, une piste supérieure électriquement conductrice (12, 13), une piste inférieure électriquement conductrice (16), une pluralité de liens transversaux électriquement conducteurs (10), dont chacun relie l'une desdites broches avec ladite piste inférieure, et une pluralité de liens latéraux conducteurs (11), dont chacun relie l'une desdites broches avec ladite piste supérieure.

2. Un circuit d'après la revendication 1, caractérisé par les caractéristiques suivantes:

(a) une pluralité de paires desdites broches, disposées sur deux rangs (7, 8), avec ladite piste inférieure située entre les deux, l'un desdits rangs (7) se trouvant entre ladite piste inférieure (16) et une première piste supérieure (12), et ledit second rang (8) se trouvant entre ladite piste inférieure et une seconde piste supérieure (13), les broches de l'un desdits rangs étant reliées par lesdits liens latéraux individuels (11) à ladite première piste supérieure, les broches dudit autre rang étant reliées par lesdits liens latéraux individuels à ladite seconde piste supérieure, et l'ensemble desdites broches étant reliées par lesdits liens transversaux individuels à ladite piste inférieure;

(b) lesdites broches sont perpendiculaires à la lamelle, sont espacées et sont parallèles entre elles; et

(c) des parties desdites pistes inférieures et desdits liens (10, 11, 15) ont une continuité électrique interrompue, pour obtenir la programmation désirée de l'interconnection.

3. Un circuit d'après la revendication 2, caractérisé par les caractéristiques suivantes:

(a) des liens d'extrémité (15) électriquement conducteurs relient entre elles ladite première piste supérieure (12), ladite seconde piste supérieure (13) et ladite piste inférieure (16);

(b) lesdites pistes supérieures et ladite piste inférieure sont parallèles entre elles et le circuit est disposé symétriquement de part et d'autre de ladite piste inférieure, avec lesdits liens (10, 11, 15) et lesdites broches disposés perpendiculairement auxdites pistes supérieures et à ladite piste inférieure;

(c) comprenant seize broches disposées en deux rangs symétriques (7, 8) de huit; et

(d) au moins une piste supérieure supplémentaire (33, 34) est disposée parallèlement auxdites première et seconde piste supérieures et est électriquement reliée de façon à être conductrice, à ladite première ou à ladite seconde piste supérieure par des extensions desdits liens latéraux (11) associés à cette piste supérieure, si on le souhaite incluant au moins une piste inférieure supplémentaire, disposée entre lesdits rangs de broches parallèles à ladite première piste inférieure et reliée à celle-ci électriquement de façon à être conductrice par des extensions desdits liens transversaux (10).

4. Un boitier programmable construit d'après le circuit selon les revendications 1, 2 ou 3, caractérisé par le fait que ladite ou lesdites pistes supérieures (12, 13) se trouvant dans un plan ou dans des plans espacés du plan dans lequel se trouve ladite piste inférieure (16), et parallèles à celui-ci, et sont superposées sur lesdits liens transversaux (10) tout en en étant écartées, et dans lequel lesdites broches sont perpendiculaires auxdits plans, à intervalles réguliers et parallèles, ladite piste inférieure et certaines parties desdits liens (10, 11 et 15) étant libres de ladite superposition, ce qui facilité le retrait sélectif des parties voulues (21) desdits liens et de ladite piste inférieure pour interrompre la continuité électrique, de façon à programmer l'interconnection entre lesdites broches de la manière souhaitée.

5. Un boitier programmable d'après la revendication 4, caractérisé par les caractéristiques suivantes:

(a) les parties superposées sont espacées les unes des autres par une couche (20) de matériau isolant de l'électricité;

(b) un coffrage isolant (4) enferme le circuit, à l'exception desdites broches (2) qui sortent dudit coffrage selon un espacement régulier et parallèle, ledit coffrage ayant des ouvertures (22) traversant lesdits plans pour donner accès auxdites parties souhaitées (21) desdits liens (10, 11, 15) et des pistes inférieures (16) afin de faciliter ledit retrait sélectif; et dans lequel

(i) lesdites ouvertures sont de préférence situées à chaque interconnection entre ladite piste inférieure et un lien, entre chaque interconnection sur ladite piste inférieure et sur chaque lien transversal;

(ii) chacune desdites ouvertures est de préférence conçue de manière à guider un poinçon (23) de retrait d'une partie d'attache; et

(c) certaines parties desdites pistes inférieures et desdits liens ont une continuité électrique interrompue afin de donner la programmation souhaitée de l'interconnection entre lesdites broches;

(d) dans laquelle les parties souhaitées dudit circuit ont une section plus petite que d'autres parties dudit circuit, ceci afin de faciliter le retrait desdites parties voulues; et

(e) ledit retrait sélectif est realise par l'application d'un courant électrique auxdites parties voulues, ledit courant étant d'une intensité suffisante pour fondre lesdites parties voulues.

6. Un boitier programmable d'après la revendication 5, caractérisé par les caractéristiques suivantes:

(a) ledit coffrage (4) est conçu de telle sorte qu'il puisse être utilisé dans un dispositif d'insertion automatique des composants d'un circuit imprimé;

(b) ledit boitier a la forme d'un boitier à deux rangées de broches en ligne; et

(c) certaines parties desdites pistes inférieures (16) et desdits liens (10, 11, 15) ont une continuité électrique interrompue de façon à donner la programmation voulue de l'interconnection entre lesdites broches.

7. Une méthode de fabrication d'un boitier programmable, caractérisée par les étapes suivantes:

(a) production d'un circuit composé d'une lamelle comprenant une pluralité de broches (2) conductrices de l'électricité, ayant un espacement constant, une piste supérieure conductrice (12, 13), une piste inférieure conductrice (16), une pluralité de liens transversaux conducteurs (10), dont chacun relie l'une desdites broches avec ladite piste inférieure, et une pluralité de liens latéraux conducteurs (11), dont chacun relie l'une desdites broches avec ladite piste supérieure.

(b) pliage desdits liens le long de lignes de pliure (18, 19), placées de telle sorte que la piste supérieure ou les pistes supérieures se trouvent dans un plan ou dans des plans espacés du plan dans lequel se trouve ladite piste inférieure et parallèle à celui-ci, et sont superposées sur lesdits liens transversaux, tout en en étant espacées, et ladite piste inférieure (16) et des parties (21) desdits liens (10, 11, 15) sont libres de la superposition, de façon à faciliter le retrait sélectif des parties voulues desdits liens et de la piste inférieure pour interrompre la continuité électrique; et

(c) courbure desdites broches pour qu'elles soient (1) perpendiculaires auxdits plans, et (2) espacées parallèlement les unes des autres.

8. Une méthode d'après la revendication 7, caractérisée par les autres étapes suivantes:

(d) retrait sélectif desdites parties (21) pour donner la programmation voulue de l'interconnection entre lesdites broches (2);

(e) enrobage dudit circuit dans un coffrage (4) avec lesdites broches faisant saillie vers l'extérieur, ledit coffrage ayant des ouvertures (22) qui donnent accès audit cicuit pour faciliter le retrait desdites parties voulues (21).

9. Une méthode d'après la revendication 7, caractérisée par les caractéristiques suivantes:

(i) les parties (21) desdites pistes inférieures (16) et desdits liens (10, 11, 15) sont enlevées avant l'étape (b);

(ii) ledit retrait sélectif est réalisé par l'application d'un courant auxdites parties voulues, ledit courant étant d'une intensité suffisante pour fondre lesdites parties voulues;

(iii) certaines parties dudit circuit ont une section réduite pour faciliter ledit pliage le long desdites lignes de pliure (18, 19); et

(iv) lesdites parties sont réalisées avec une section plus petite que celle d'autres elements dudit circuit.

10. Une méthode d'après les revendications 7, 8 ou 9, caractérisée par l'application d'un courant électrique auxdites parties voulues (21) dudit circuit, ledit courant étant d'une intensité suffisante pour fondre lesdites parties.

11. Une méthode d'après la revendication 10, caractérisée par le fait que lesdites parties (21) sont formées avec une section plus petite que celle d'autres éléments dudit circuit.

FIG. 4

FIG. 5

FIG. 1

FIG. 2

*FIG. 3*

0 081 986

2A  2B  2C  2D  2E  2F  2G  2H

*FIG. 7*

2I  2J  2K  2L  2M  2N  2O  2P

2A  2B  2C  2D  2E  2F  2G  2H

*FIG. 8*

2I  2J  2K  2L  2M  2N  2O  2P

FIG. 9

FIG. 6

FIG. 10

0 081 986

FIG. 15

FIG. 14

FIG. 17

FIG. 16

FIG. 13

FIG. 12

FIG. 11